Europäisches Patentamt

European Patent Office

Office européen des brevets

(19)

(11) Publication number: **0 101 174**
**B1**

# EUROPEAN PATENT SPECIFICATION

(12)

(45) Date of publication of patent specification: **22.10.86**

(51) Int. Cl.⁴: **H 03 F 3/16**

(21) Application number: **83303922.5**

(22) Date of filing: **05.07.83**

(54) Monolithic low noise common-gate amplifier.

(30) Priority: **06.07.82 US 395399**
**06.07.82 US 395416**

(43) Date of publication of application:
**22.02.84 Bulletin 84/08**

(45) Publication of the grant of the patent:
**22.10.86 Bulletin 86/43**

(84) Designated Contracting States:
**DE FR GB IT NL**

(56) References cited:
**GB-A-2 057 803**

**MTT SYMPOSIUM PROCEEDINGS 1981 W.C.
PETERSEN et al. "A monolithic GaAs 0.1 to 10
GHz amplifier", pages 354-355**

**IEEE INTERNATIONAL SOLID-STATE CIRCUITS
CONFERENCE, vol. 25, 11 February 1982, New
York, D.B. ESTREICH "A wideband monolithic
GaAs IC amplifier", pages 194-195, 318**

**IEEE INTERNATIONAL SOLID-STATE CIRCUITS
CONFERENCE, 11 February 1982 R.E.
LEHMANN et al. "10GHz 3-stage monolithic
4dB noise figure amplifier", pages 140-141**

(73) Proprietor: **TEXAS INSTRUMENTS
INCORPORATED**
**13500 North Central Expressway
Dallas Texas 75265 (US)**

(72) Inventor: **Brehm, Gailon E.
2219 Heather Hill
Plano Texas 75075 (US)**
Inventor: **Lehmann, Randall E.
902 Century Park Drive
Garland Texas 75040 (US)**
Inventor: **Seymour, David J.
3117 Natalie
Plano Texas 75074 (US)**

(74) Representative: **Abbott, David John et al
Abel & Imray Northumberland House
303-306 High Holborn
London, WC1V 7LH (GB)**

(56) References cited:
**MTT SYMPOSIUM PROCEEDINGS, 1981 R.S.
PENGELLY et al. "A comparison between
actively and passively matched S-band GaAs
monolithic FET amplifiers", pages 367-369**

Courier Press, Leamington Spa, England.

0 101 174

(58) References cited:
**L'ONDE ELECTRIQUE, vol. 61, no. 11, November 1981, Paris H.F. COOKE "Les transistors à effet de champs micro-ondes", pages 17-23**

## Description

### Background of the Invention

A great many high-frequency system applications require a low-noise input stage which has good input impedance matching at microwave frequencies.

A principal area of developing technology, where a crucial need for low-noise amplifiers exist, is in the area of microwave receivers. The crucial first step in any microwave receiver system is to amplify the rf signal, as received at the antenna, to raise it above the background of thermal and other noise. It is particularly desirable to be able to provide such a low-noise input stage in an integrated embodiment. Such low-noise input stages are required in, for example, conventional radar, phased-array radar, uplink and downlink stages of satellite communications receivers, home TV RO (television receiver only) systems, police radar, intrusion alarm systems, microwave point-to-point relay systems, and mobile radio systems.

A further area of applications, where critical need for such low-noise integrated input stages exists, is in sensors. In many sensor applications, the compactness and economy permitted by an integrated design is even more critical than in receivers. In particular, low-noise microwave amplifiers are needed for pollution monitoring equipment. In such systems, microwave resonant absorptions characteristic of various pollution components can be used to determine the type and density of a particular pollutant with extreme precision, by remote microwave sensing. Similarly, in petrochemical processing, microwave sensing can be used for very accurate detection of the percentage of methane or other process components in a process gas stream. Low-noise microwave amplifiers are also needed for sensing of environmental microwave radiation, to detect and measure possible human health hazards. Finally, an additional biomedical application is radiometry, in which the amount of microwave radiation applied to or transmitted through living tissue must be precisely measured.

Two basic approaches are currently being employed in the design of monolithic low noise amplifiers. The conventional approach uses an input FET in a common-source configuration with the necessary input matching circuitry to achieve minimum noise figure. See Lehman, Brehm and Westphal, "*1982 IEEE International Solid State Circuits Conference Digest of Papers*, Feb. 11, 1982, pp. 140—141. This design can achieve very low noise figure, but also has a high input voltage standing wave ratio (VSWR) (typically 3:1 or 4:1) because the input matching circuit presents the required noise match impedance for minimum noise figure rather than a conjugate match. Because of the high input VSWR, this design must incorporate a 3 dB hybrid (coupler) at the input and output to integrate into any receiver. This balanced configuration requires a matched pair of amplifiers as well as a 3 dB hybrids at the input and output. This approach, when implemented monolithically, consumes a great deal of GaAs real estate. It would be highly desirable to have a single ended amplifier design.

The second approach employs an input FET in a common-gate configuration, often referred to as "active-matching". This design achieves good input VSWR but at the expense of degrading the noise figure. Such an approach has been demonstrated by Petersen et al, see "Monolithic GaAs Microwave Analog Integrated Circuits", *Interim Report for ERADCOM*, Sept. 1980, and Estreich, "A Wideband Monolithic GaAs IC Amplifier", 1982, *IEEE International Solid State Circuits Conference Digest of Papers*, Feb. 11, 1982, pp. 194—195. See also Pengelly et al, "A Comparison between Actively and Passively Matched S-band GaAs Monolithic FET Amplifiers", *MTT Symposium Digest of Papers 1981*, pp. 367—369. In this prior art, the common-gate FET is operated at a bias condition to achieve a device transconductance, $g_m$, of approximately 20 mS. Because the input impedance of a common-gate FET is approximately $1/g_m$, the input impedance is nominally 50 ohms. At this bias condition, input VSWR is optimized over a broadband of frequency, but one sacrifices often the most critical performance parameter, noise figure.

A monolithic common-gate amplifier was published in 1981, in the proceedings of the MTT Symposium. See Petersen et al, "A Monolithic GaAs 0.1 to 10 GHz Amplifier", *MTT SYMPOSIUM PROCEEDINGS* at page 354. This device does not disclose the air bridge configuration or other features of the described embodiment of the present invention.

In prior art monolithic microwave integrated circuits (MMICs) which have used GaAs FETs in a common-source configuration, the source regions (usually three or more regions) are connected to ground potential areas of the circuit in a low-inductance manner, the input signal is applied to the gate, and the output signal is taken from the drain. In such monolithic FET configurations, the source regions are connected to the expanded ground areas using plated gold air bridges when it is necessary to cross over the gate feeds. The input gate transmission line is split into two or more feeds as is the output drain transmission line. The submicrometer gate itself is a single line located vertically between the source and drain regions. This "pi-gate" device design provides low output-to-input feedback capacitance and uniform phasing along the device.

A key requisite in realizing a common-gate amplifier monolithically is a low and repeatable gate inductance. If the gate inductance is not low, it may lead to instability. If the gate inductance is not repeatable, the resulting device inconsistency will not permit economical integrated circuit fabrication techniques.

It is an object of the present invention to provide an improved low noise microwave amplifier.

According to the present invention there is provided a microwave amplifier for amplifying an input signal received over a line having a predetermined impedance comprising a first field-effect transistor having a bias current through it and of which the source is connected to receive the input signal, the gate is grounded, and a load impedance means is connected to the drain, the impedance of the load being greater than the impedance of the input signal line, and an additional amplifier stage which is connected to said drain of said field effect transistor, characterised in that the bias current is selected so that the transistor has a very low noise figure and that the gate of the transistor has a width such that the transconductance of the transistor at the selected bias current is greater than the reciprocal of the impedance of the input signal line.

Computer modeling at TI has shown that the noise figure can be considerably improved if the FET can be operated at higher values of transconductance.

A low noise amplifier according to the invention achieves a combination of input match and low-noise performance not previously available. The device transconductance of the FET used in the common-gate input stage is raised to a transconductance higher than the reciprocal of the input impedance. This higher device transconductance places the device in its low-noise regime. Input match is then achieved by using a high load impedance for the common-gate stage. The load impedance is *not* a conjugate match to the output impedance. Because of the drain-source capacitance of the common-gate FET, the higher load impedance presented to the output of the common-gate device also means that the common-gate device presents a higher input impedance at the input of the device. The high load impedance used has the further advantage that the voltage gain of the common-gate device is maximized, which produces a high signal-to-noise (S/N) ratio. The common-gate input stage is then preferably followed by one or more common-source stages, to achieve the necessary total gain and/or power. Very low noise and very good input match is achieved at the input stage of the amplifier, where it is most critical.

In order to provide low and exactly repeatable common lead inductance (gate lead inductance) and low feedback parasitics in a common-gate low noise amplifier, the GaAs FET connects the gate electrode to ground at various points along its width by means of an air bridge crossover structure. This structure crosses over the input (source) lines with very low capacitance. Since the gate lead inductance is low in this design, and because in monolithic form this inductance does not vary as is the case for a device grounded using bond wires, common-gate circuit stability is assured. This device preferably uses the well-known pi-gate configuration to provide low drain-gate parasitic capacitance and equal phasing to all parts of the device.

These three features — air bridge interconnection of the gate feed points to ground, multiple feedpoints to the source input and drain output, and the "pi-gate" device design — provide the low and repeatable gate inductance, low output-input feedback, and equal phasing essential for a stable, high-performance common-gate amplifier.

Brief Description of the Drawings

The present invention will be described with reference to the accompanying figures, wherein:

FIGURE 1 is a circuit diagram of a sample embodiment of the amplifier of the present invention;

FIGURE 2 shows an equivalent circuit for an FET;

FIGURE 3 shows the preferred device configuration used in the inventive amplifier;

FIGURES 4—7 show the relation between the real part of the load impedance and the real part of the input impedance for various gate widths, at 10 GHz; and

FIGURE 8 shows equivalent circuits for the input and output impedances of the FET device.

Description of the Preferred Embodiments

The monolithic low noise amplifier of the present invention employs a common-gate FET for active matching at the input, operated at an optimum transconductance to achieve low noise figure. One or more common-source stages are driven by the common-gate stage to provide an adequate total gain. The amplifier is preferably integrated monolithically on a GaAs substrate, to achieve tighter control of circuit and device parasitics than can be achieved with a hybrid (discrete FET) implementation. This design makes use of the drain-to-source feedback properties (specifically, the drain-source capacitance) of a common-gate FET. Proper impedance loading at the drain of the FET yields an input impedance of 50 ohms, or other input impedances as required for specific system applications. The high load impedance presented to the output of the FET also provides high voltage gain, which is important in maximizing the signal-to-noise ratio (S/N) through the first stage of the low noise amplifier.

This is the first demonstration of common-gate active matching with a high device transconductance to achieve both low input VSWR and low noise figure. For bandwidths on the order of 10—30%, this design technique allows single-ended performance without degrading the noise figure. For most radar and satellite receiver applications only 10—20% bandwidths are required, thus giving an excellent opportunity to use single-ended low noise amplifiers with good input VSWRs and low noise figures. The FET used for active matching occupies less GaAs real estate than a passive matching circuit (distributed transmission lines and capacitors) as might be used in a conventional common-source input low noise amplifier. A common-gate low noise amplifier will consume approximately four times less GaAs than the balanced common-source low noise amplifier. This fact alone greatly reduces cost and complexity and improves yield and reliability.

The performance tradeoff one must tolerate is bandwidth versus noise figure. Large bandwidths (greater than an octave) are achieved with prior art techniques by employing the necessary first stage load impedance. This load impedance is proportional to the Q required for the circuit. Thus, broadband operation requires low Q circuits, resulting in lower voltage gains and higher noise figures. The noise figure-bandwidth tradeoff must be addressed for each specific application.

Though active matching with common-gate FETs is applicable to many microwave components (e.g., power amplifiers, switches, attenuators, etc.), the present invention is specific to low noise amplifiers where the achievement of high voltage gain, low noise figure and good input VSWR are possible.

Thus, the key idea of the present invention is that the channel conditions are optimized for low-noise performance, independently of input matching requirements. The conventional wisdom teaches that minimum-noise operation is achieved at a channel current of about 15% of the saturated current ($I_{DSS}$). However, better low-noise optimization has been found to be achieved at a channel bias current of 30 to 50 microamperes per micron of gate width. Thus, for example, where a 300 micron FET is used for the common-gate stage (as is presently preferred), a bias current in the neighborhood of 10 to 15 milliamps is preferred.

After the channel current density has been selected to achieve minimum noise, the gate width is selected to achieve the desired high transductance at the low-noise gate current density. The longer the device gate width is, the higher the transconductance is. Thus, gate widths as large as possible are desirable, subject to the constraints of power consumption and real estate. That is, very wide gates will consume significant amounts of power, which is often undesirable in microwave receiver applications.

A further advantage of using wide gates is that a wider-gate device inherently generates less noise, under analogous operating conditions, than does a narrower-gate device. The equivalent input noise voltage is inversely proportional to the square root of the gate width of the device. Devices having very large gate widths have not been preferred in such applications in the prior art, since the device input impedance normally becomes quite low and the device therefore becomes difficult to match.

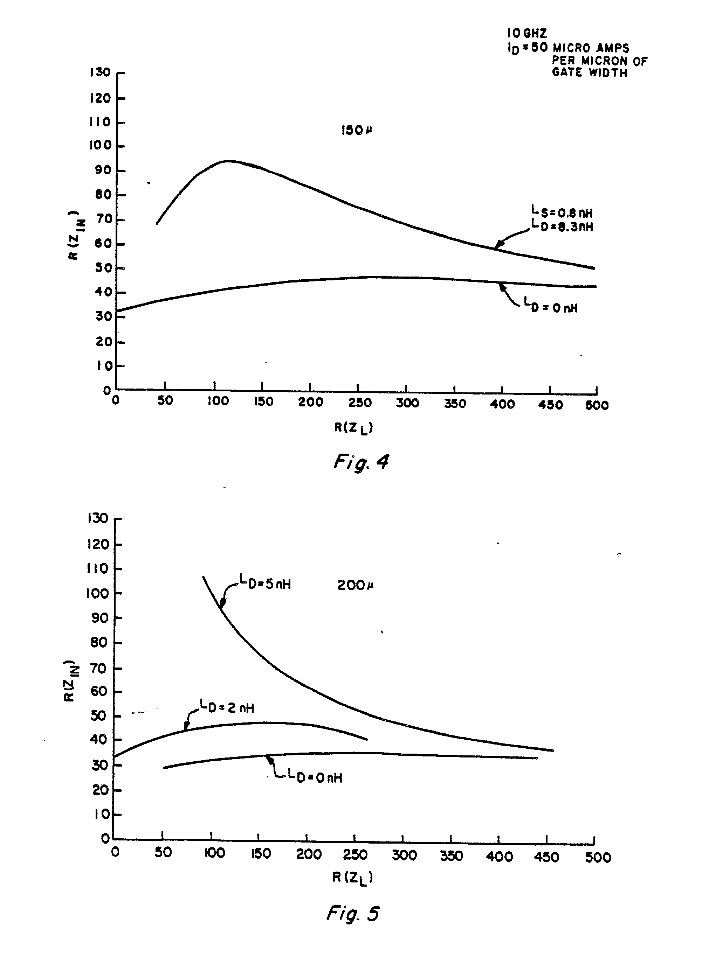

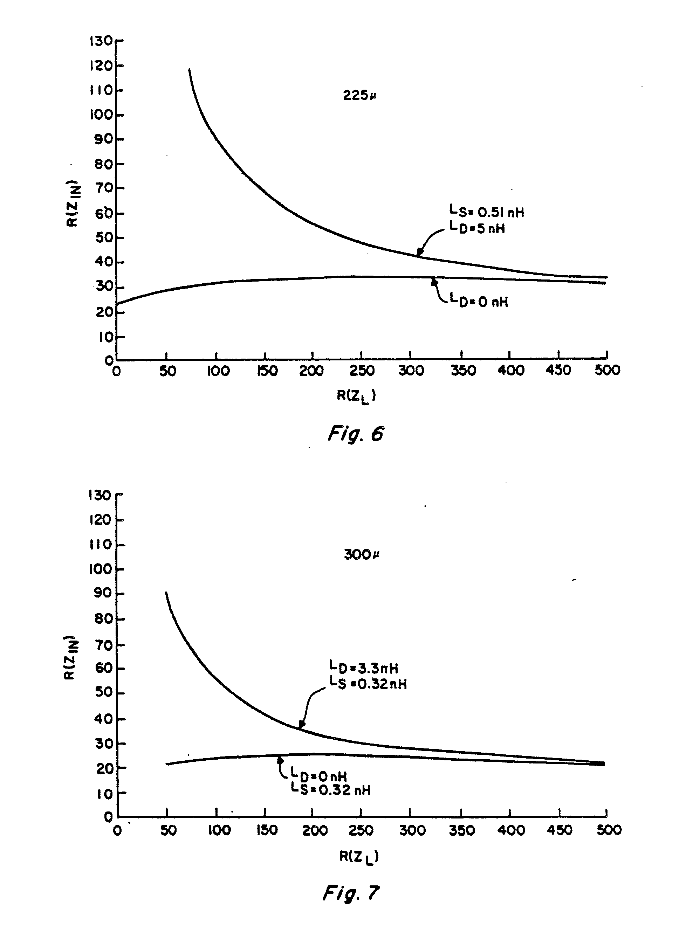

Typically FET is as such as those preferred will show a significant reactive component and their output impedance at the frequencies of interest. For example, at 10 GHz, a reactive component equivalent to the shunt capacitance shown in Figure 8 will typically appear. Preferably this reactive component is conjugately matched, e.g. by a series inductance in the interstage load circuit. This inductance is used to achieve broader frequency bandwidth, but it should be noted that a full conjugate match is *not* used, since the real component of the device output impedance is not matched. The selection of low impedance is more clearly seen in Figures 4—7. For example, in Figure 7, which relates to a 300 micron gate width device at 10 GHz, the upper curve shows a circuit where a 3.3 nanohenry inductance has been used to compensate the reactive output impedance of the device. In this case, to achieve a 50 ohm real input impedance, the real part of the load impedance is selected to be approximately 110 ohms. Similarly, with a 225 micron gate width device, the real part of the load impedance can be made as high as 240 ohms while still preserving perfect input match, if a reactive component $L_D$ of 5 nanohenries is used to compensate the reactive component of the output impedance. Similarly, with a 200 micron gate width device, a load impedance having a real component of 290 ohms can be used at this same frequency, where a 5 nanohenry $L_D$ reactive component is used.

It is also sometimes useful to use a source-trimming reactance $L_S$, to adjust the imaginary component of the input impedance to zero. This component will typically also be a series inductance, and its value will be typically less than a nanohenry. The use of this input reactive-trimming component depends on device characteristics and frequency range, and frequently is not necessary at all.

A further area where trimming may be useful is adjusting of the bias current. That is, since the components used to define the load impedance may be slightly inaccurate, adjustment of the bias current within the low noise regime can be used to find-tune the input match. Of course, use of decreased bias current can lower the device transconductance and thereby assure input match, but this method sacrifices the low-noise advantages to which the present invention is primarily directed. That is, when a 300 micron device is biased in the low-noise regime, it will typically exhibit a transconductance in the neighbourhood of 60 mS, but use of smaller bias currents could alter the same devices transconductance to 20 ms, which would result in a broad-band high-noise circuit very like that taught by the prior art.

In the paired curves of Figures 4—7, the lower curve on each figure indicates a purely resistive load impedance. Thus, these two curves (or the three curves of Figure 5) merely provide examples of the variety of curves in between. It is also alternatively possible to use a greater reactive impedance in the load impedance circuit than required for conjugate match to the reactive portion of the output impedance of the device, but this is not presently preferred. However, this embodiment is within the scope of the present invention. Using this alternative, it is possible to use a load impedance having a real part which is even slightly higher than that otherwise possible.

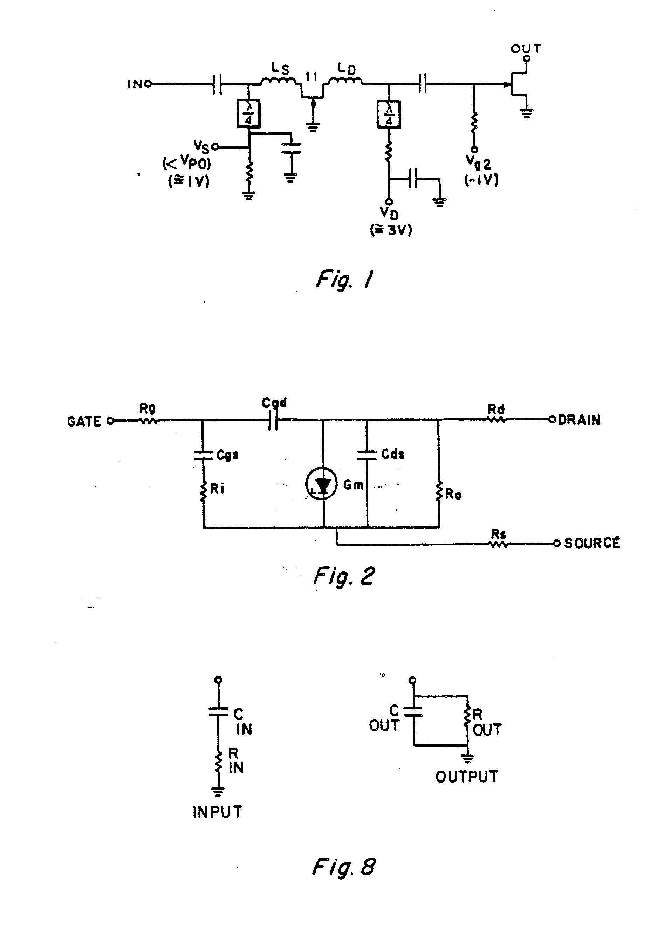

To select the load impedance for input matching, several methods can be used. Alternatively, empirical matching, based on the characteristics of the actual device used, can of course be applied. For example, careful dc and rf characterization of the GaAs FET provides the foundation for the predicted amplifier performance and the circuit components that will be required. An FET is mounted on a metal carrier (typically KOVAR, molybdenum, or copper) with solder and attached to 50 ohm microstrip transmission lines with bond wires. This test fixture provides an easy method for evaluating the rf properties of the transistor in a 50 ohm system. If the measurement system employs a different characteristic impedance (e.g., 75 ohm for the telephone industry), the appropriate microstrip characteristic impedance would be preferred. Measurement of dc parameters of the device can be made on the chip prior to or after mounting on the metal carrier. To determine the intrinsic device properties at microwave frequencies, scattering-parameters (S-parameters) are measured across a broadband of frequencies. The S-parameters treat the device as a 2-port entity, describing the input impedance ($S_{11}$), the output impedance ($S_{22}$), the forward transmission coefficient ($S_{21}$), and the reverse transmission coefficient ($S_{12}$). S-parameters are measured with the FET operating at the bias conditions that will be assumed in the final design. For the first stage of a multi-stage low noise amplifier, this bias condition is determined by finding the voltages and currents required to optimize the device noise figure and gain at the desired frequency or frequencies. Knowing the dc and rf properties of the FET, an equivalent circuit model is then derived with the aid of a computer. A simple hybrid equivalent circuit, shown in Fig. 2, is used to simulate the device. Either a search routine or an optimization routine is then used to determine possible load impedances with which, when connected to the output (drain) of the FET, an input impedance of 50 ohms can be achieved. For designs in which a specific bandwidth is required, the input impedance is examined across the entire frequency range, and $Z_L$ adjusted accordingly to maintain nearly constant 50 ohm input impedance. Of particular interest to this design procedure is an accurate determination of the series equivalent input impedance and the parallel equivalent output impedance. Using these equivalent circuits, initial values for circuit components are picked to optimize the load impedance ($Z_L$) of the first stage so that the magnitude of $Z_L$ can be maximized while also maintaining the constraints on $Z_L$ which provide a device input impedance of approximately 50 ohms. One desires to maximize $Z_L$ across the required frequency band so as to maximize the voltage gain of the first stage. Because an FET operated in a common-gate configuration has unity current gain, the voltage gain, $A_V$, is simply the ratio of the load impedance, $Z_L$, to the input impedance, $Z_{IN}$: $A_V = Z_L/Z_{IN}$. The load impedance seen by the first stage is a complex impedance consisting of the interstage circuitry and the input impedance of the second stage FET. The interstage circuitry can be designed with an infinite number of combinations of lumped-element (inductors, capacitors, and resistors) and/or distributed (transmission lines, microstrip, open- and short-circuited stubs) components. In the presently preferred design, a quasi-lumped-element approach was taken. The initial design was done with lumped-element components, using shunt inductors for impedance matching and biasing. Inductors are modeled as high-impedance transmission lines in the final monolithic design optimization.

As part of the analysis of the final design, the amplifier performance can be examined with the aid of one or more computer programs. SPICE2 computes the noise voltages associated with the resistive components in the devices and the rf circuitry. This routine permits an analysis of where the major contributions to noise are occurring and the voltage gains of each stage of the low noise amplifier. If the load impedance to the first stage is not correct, the voltage gain calculation will bear this out. If the voltage gain is lower than anticipated, the noise figure will also be degraded. To achieve minimum noise figure, the voltage gain must be maximized to improve the S/N ratio, while still maintaining the desired input impedance. COMPACT, another computer-aided design program, is also used to optimize gain, input and output VSWR, and examine the stability of the low noise amplifier.

The physical layout of the monolithic circuit is important to achieving the desired performance of the low noise amplifier. One of the critical aspects of the common-gate low noise amplifier design is the repeatable performance of the common-gate FET. This is preferably achieved by having a fully monolithic chip capable of providing low and exactly repeatable gate lead inductance. This helps to ensure stability of the amplifier. This low noise amplifier also employs pi-gate type FETs and air bridge crossover structures to connect portions of the FET to ground and to connect capacitor top plates to rf transmission lines.

Thus, the present invention provides the key feature of a very low-noise input stage, which has a very good input impedance match. The common-gate input stage is necessarily followed by at least one additional amplifying stage. The following stages may be either common source or source-follower stages. In the presently preferred embodiment, the common-gate input stage is followed by at least one common-source stage, as shown in Figure 1. Note that the higher load impedance used, according to the present invention, for the load presented to the first (common-gate) stage means that a substantial mismatch is caused at the input to the second stage. However, this mismatch does not matter, since the present invention is directed to achieving good voltage transfer into the second stage, but power transfer at this point is not important. That is no attempt is made to match the real part of the output impedance of the grounded-gate FET. Of course, more than one following stage, after the input stage, can alternatively be used. Sourcefollower final stages can also be used, to achieve a broader-band output match.

As shown in Figure 1, the presently preferred embodiment uses a separate bias supply in the common-gate amplifier stages. That is, the connection $V_S$ is used to specify the bias point of the FET 11, and the connection $V_D$ is used for the higher-voltage supply. Thus, for example, a 300 micron device is used in the presently preferred embodiment, having a pinch off voltage of about one and one half volts. In this case, about one volt would be supplied to terminal $V_S$ for biasing, and about three volts would be supplied to terminal $V_D$ to achieve voltage gain.

In the preferred integrated embodiment, the inductors shown are configured as quasi-lumped elements, that is as short sections of mismatched transmission line, i.e. having an impedance higher than the surrounding transmission lines portions. Capacitors are preferably configured as MIM capacitors, using a silicon nitride dielectric. The substrate is preferably semi-insulating (chromium-doped gallium arsenide). The particular device structure preferably used for the grounded-gate FET 11 is discussed in greater detail below.

Many features can be added to the common-gate low noise amplifier to improve its performance and its implementation in systems. The low noise amplifier can be biased with a single supply. This has a decided advantage in many systems. The active devices can be "self-biased" with the use of monolithic resistors. Dual-gate FETs will be employed to provide gain and/or phase control or trimming. Monolithic diodes will be used for rf power limiting, voltage regulation and reactive impedance loading (varactor diodes). Various A/D or D/A circuitry can be added to provide compatibility with TTL or other control systems. Monolithic switches can be incorporated to permit redundant low noise amplifiers or receivers on the same chip, or to allow switching of two or more low noise amplifiers to receive several frequency bands.

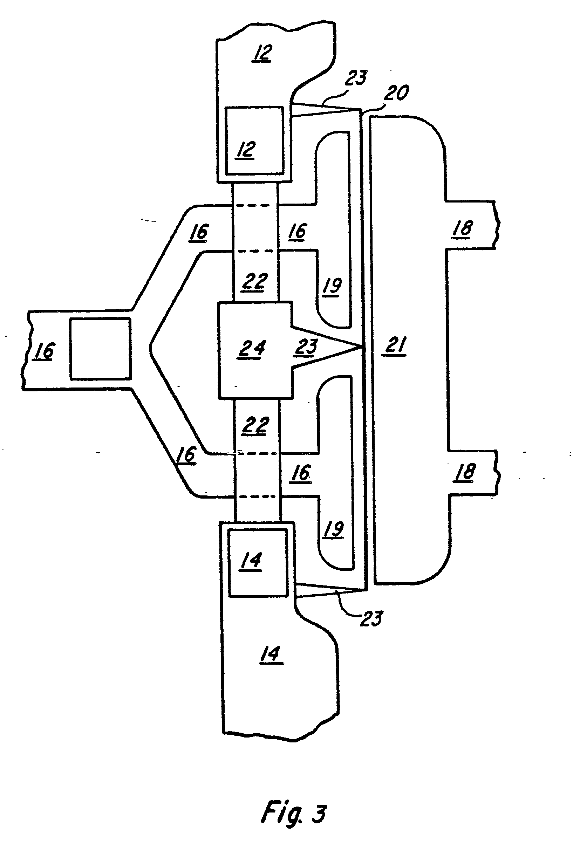

Preferably, in order to provide low and exactly repeatable common lead inductance (gate lead inductance) and low feedback parasitics in a common-gate GaAs FET amplifier, the gate electrode is connected to ground at various points along its width by means of an air bridge crossover structure. This structure crosses over the input (source) lines with very low capacitance. Since the gate lead inductance is low in this design, and because in monolithic form this inductance does not vary as is the case for a device grounded using bond wires, common-gate circuit stability is assured. This device preferably uses the well-known pi-gate configuration to provide low drain-gate parasitic capacitance and equal phasing to all parts of the device. This device structure is shown in Figure 3.

These three features — air bridge interconnection of the gate feed points to ground, multiple feedpoints to the source input and drain output, and the "pi-gate" device design — provide the low and repeatable gate inductance, low gate-drain feedback, and equal phasing essential for a stable, high-performance common-gate amplifier.

The preferred embodiment combines the advantages of the basic "pi-gate" GaAs FET device design with the circuit performance advantages achieved by the common-gate configuration. Figure 1 shows that in the common-gate configuration, the FET gate is connected to ground in a low-inductance fashion, the input signal is applied to the source, and the output is taken from the drain. This configuration offers very good input match along with good noise figure. Problems with poor stability and poor control of parasitics have previously limited the implementation of this important circuit configuration.

The monolithically integrated common-gate microwave pi-gate GaAs FET provides the performance advantages of common-gate circuits without any stability problem. This novel device design, shown in Figure 3, provides an air-bridge interconnection of the gate feed points to ground. As a result, the gate-to-ground inductance is minimal and is exactly repeatable from device to device. The pi-gate configuration with the single gate stripe located in a vertical line between the source and drain provides minimum feedback capacitance. Multiple gate and drain feeds are used to provide equal phasing over the whole device.

Figure 3 shows an example of a device configuration according to the present invention. A gate 20 lies between a source 19 and a drain 21. In the presently preferred embodiment, the gate 20 is one-half micron long and 300 microns wide, but these dimensions may be varied as desired. Source and drain feeds 16 and 18 are provided to connect to the source and to the drain respectively, at separated points along their length. This provides the advantage of equal phasing across the device, and avoids ohmic losses. Contact to the gate is then made through fingers 23, which contact the gate stripe 20 at intervals along its length. While the end point contacts can be connected directly to ground planes 12 and 14, this is not possible in a planar configuration where more than two contacts to the gate are made. However, it is highly desirable to have more than two contacts to the gate, to avoid inductive reactance and ohmic loss in the gate circuit. Thus, in the present invention, one or more additional fingers 23 lead from the gate to one or more additional gate pads 24, and these additional gate pads 24 are connected to the ground planes 12 or 14 by means of air bridges 22. A key advantage of these air bridges is that they provide an extremely low capacitive coupling between the gate and source circuit.

This is particularly important where very long gates are used. Since, as noted above, it is desirable to use extremely long gate widths for low-noise applications, the present invention provides a configuration by means of which very large gate widths (up to thousands of microns) can easily be realized. The process steps which are used to fabricate the device of the present invention are conventional to gallium arsenide processing. For example, in a chromium-doped semi-insulating gallium arsenide substrate, a mesa etch is first used to define the active regions. The ohmic contact metal is then patterned and deposited. (Preferably this metal is gold/germanium/nickel.) The gate metal is then defined and deposited. (Preferably this comprises sequential layers of titanium, platinum, and gold.) The source/drain overlay metal is then defined and deposited (preferably this comprises sequential layers of titanium and gold.) Finally, the gold air bridges are defined and plated. Processing then continues with other conventional steps to complete the desired integrated circuit.

Thus it is an advantage of the present invention that a common-gate active device is provided which has very low and exactly repeatable gate lead inductance.

It is a further advantage of the present invention that a common-gate active device is provided which has low parasitic capacitances.

Thus, the present invention provides a crucial new ionnovation in low-noise microwave amplifiers. In particular, the present invention makes possible a new degree of performance in microwave receivers. In addition, the present invention is integrated low-noise amplifier, providing further economical advantages.

Moreover, the present invention provides very low noise performance in a room-temperature receiver.

Thus, due to these advantages, the present invention is crucially important in the art of microwave receivers. However, it is also of substantial importance in a wide variety of other microwave amplification applications. The scope of the present invention is therefore not limited except as set forth in the following claims.

**Claims**

1. A microwave amplifier for amplifying an input signal received over a line having a predetermined impedance comprising a first field-effect transistor having a bias current through it and of which the source is connected to receive the input signal, the gate is grounded, and a load impedance means is connected to the drain, the impedance of the load being greater than the impedance of the input signal line, and an additional amplifier stage which is connected to said drain of said field effect transistor, characterised in that the bias current is selected so that the transistor has a very low noise figure and that the gate of the transistor has a width such that the transconductance of the transistor at the selected bias current is greater than the reciprocal of the impedance of the input signal line.

2. A microwave amplifier according to claim 1 characterised in that the resistive part of the impedance of the load is greater than the resistive part of the output impedance of the field effect transistor.

3. An amplifier according to claim 1 or 2, characterised in that the field effect transistor is a MESFET.

4. An amplifier according to claim 3, characterised in that the MESFET has a gallium arsenide channel region.

5. An amplifier according to any preceding claim, characterised in that the additional amplifier stage is a common-source amplifier stage comprising a second field effect transistor of which the gate is operatively connected to the drain of said first transistor, and one of the drain and the source of the second transistor is operatively connected to the gate of said first transistor, the second transistor providing an output from the other one of the drain and the source of said second transistor.

6. An amplifier according to claim 1 or 2, characterised in that the load impedance is sufficiently high that the source of the first field effect transistor provides a match to the impedance of the input signal line in the neighbourhood of a predetermined microwave frequency.

7. An amplifier according to claim 5, characterised in that said second transistor amplifier stage is further connected to the input of an additional amplifier stage.

8. An amplifier according to claim 1 or 2, characterised in that the additional amplifier stage comprises a source-follower field effect transistor amplifier stage of which the gate is operatively connected to the drain of the first transistor.

9. An amplifier according to claim 1 or 2, characterised in that the gate of the first transistor has a width of at least 300 microns.

10. An amplifier according to claim 1 or 2, characterised in that the bias current through the channel of the first transistor is in the range of 30 to 60 microamperes per micron of gate width of the first transistor.

**Patentansprüche**

1. Mikrowellenverstärker zum Verstärken eines Eingangssignals, das über eine Leitung empfangen wird, die eine vorbestimmte Impedanz hat, mit einem ersten Feldeffekttransistor, durch den ein Vorstrom fließt und dessen Source-Elektrode zum Empfangen des Eingangssignals angeschlossen ist, dessen Gate-Elektrode an Masse liegt und an dessen Drain-Elektrode eine Lastimpedanzvorrichtung angeschlossen ist, deren Impedanz größer als die Impedanz der Eingangssignalleitung ist, und einer zusätzlichen Verstärkerstufe, die an die Drain-Elektrode des Feldeffekttransistors angeschlossen ist, dadurch gekennzeichnet, daß der Vorstrom so gewählt ist, daß der Transistor eine sehr kleine Rauschzahl hat, und daß die Gate-Zone des Transistors eine solche Breite hat, daß die Steilheit des Transistors bei dem gewählten Vorstrom größer als der Kehrwert der Impedanz der Eingangssignalleitung ist.

2. Mikrowellenverstärker nach Anspruch 1, dadurch gekennzeichnet, daß der ohmsche Teil der Impedanz der Last größer als der ohmsche Teil der Ausgangsimpedanz des Feldeffekttransistors ist.

3. Verstärker nach Anspruch 1 oder 2, dadurch gekennzeichnet, daß der Feldeffekttransistor ein MES-Feldeffekttransistor ist.

4. Verstärker nach Anspruch 3, dadurch gekennzeichnet, daß der MES-Feldeffekttransistor eine Galliumarsenid-Kanalzone hat.

5. Verstärker nach einem der vorhergehenden Ansprüche, dadurch gekennzeichnet, daß die zusätzliche Verstärkerstufe eine Verstärkerstufe in Source-Schaltung mit einem zweiten Feldeffekttransistor ist, dessen Gate-Elektrode wirkungsmäßig mit der Drain-Elektrode des ersten Transistors verbunden ist, wobei die Drain-Elektrode oder die Source-Elektrode des zweiten Transistors wirkungsmäßig mit der Gate-Elektrode des ersten Transistors verbunden ist und wobei der zweite Transistor einen Ausgang jeweils an der anderen der Drain-Elektrode oder der Source-Elektrode bildet.

6. Verstärker nach Anspruch 1 oder 2, dadurch gekennzeichnet, daß die Lastimpedanz ausreichend hoch ist, daß die Source-Elektrode des ersten Feldeffekttransistors eine Anpassung an die Impedanz der Eingangssignalleitung in der Nähe einer vorbestimmten Mikrowellenfrequenz ergibt.

7. Verstärker nach Anspruch 5, dadurch gekennzeichnet, daß die den zweiten Transistor aufweisende Verstärkerstufe außerdem an den Eingang einer weiteren Verstärkerstufe angeschlosssen ist.

8. Verstärker nach Anspruch 1 oder 2, dadurch gekennzeichnet, daß die zusätzliche Verstärkerstufe eine Verstärkerstufe mit einem Feldeffektransistor in Source-Folger-Schaltung aufweist, dessen Gate-Elektrode wirkungsmäßig mit der Drain-Elektrode des ersten Transistors verbunden ist.

9. Verstärker nach Anspruch 1 oder 2, dadurch gekennzeichnet, daß die Gate-Zone des ersten Transistors eine Breite von wenigstens 300 µm hat.

10. Verstärker nach Anspruch 1 oder 2, dadurch gekennzeichnet, daß der Vorstrom durch den Kanal des ersten Transistors in der Größenordnung von 30 bis 60 µA pro µm der Gate-Breite des ersten Transistors beträgt.

## Revendications

1. Amplificateur d'hyperfréquences destiné à amplifier un signal d'entrée reçu sur une ligne ayant une impédance prédéterminée, comportant un premier transistor à effet de champ dans lequel circule un courant de polarisation et dont la source est connectée pour recevoir le signal d'entrée, la grille est à la masse et une impédance de charge est connectée au drain, l'impédance de la charge étant supérieure à l'impédance de la ligne de signal d'entrée, et un autre étage amplificateur qui est connecté audit drain du transistor à effet de champ, caractérisé en ce que le courant de polarisation est choisi pour que le transistor présente un très faible chiffre de bruit et que la grille du transistor ait une largeur telle que la transconductance du transistor au courant de polarisation choisi soit supérieure à l'inverse de l'impédance de la ligne du signal d'entrée.

2. Amplificateur d'hyperfréquences selon la revendication 1, caractérisé en ce que la partie résistive de l'impédance de la charge est supérieure à la partie résistive de l'impédance de sortie du transistor à effet de champ.

3. Amplificateur selon la revendication 1 ou 2, caractérisé en ce que le transistor à effet de champ est un MESFET.

4. Amplificateur selon la revendication 3, caractérisé en ce que le MESFET comporte une région de canal en arséniure de gallium.

5. Amplificateur selon l'une quelconque des revendications précédentes, caractérisé en ce que l'autre étage d'amplificateur est un étage d'amplificateur à source commune comprenant un second transistor à effet de champ dont la grille est connectée au drain dudit premier transistor, et l'un du drain et de la source du second transistor est connecté à la grille dudit premier transistor, le second transistor produisant une sortie à partir de l'autre du drain et de la source dudit second transistor.

6. Amplificateur selon la revendication 1 ou 2, caractérisé en ce que l'impédance de charge est suffisamment élevée pour que la source du premier transistor à effet de champ assure une adaptation avec l'impédance de la ligne du signal d'entrée dans le voisinage d'une hyperfréquence prédéterminée.

7. Amplificateur selon la revendication 5, caractérisé en ce que ledit second étage amplificateur à transistor est en outre connecté à l'entrée d'un étage amplificateur supplémentaire.

8. Amplificateur selon la revendication 1 ou 2, caractérisé en ce que l'étage d'amplificateur supplémentaire consiste en un étage d'amplificateur à transistor à effet de champ suiveur de source dont la grille est connectée au drain du premier transistor.

9. Amplificateur selon la revendication 1 ou 2, caractérisé en ce que la grille du premier transistor a une largeur d'au moins 300 microns.

10. Amplificateur selon la revendication 1 ou 2, caractérisé en ce que le courant de polarisation dans le canal du premier transistor se situe dans la plage de 30 à 60 µA par micron de largeur de grille du premier transistor.

INO

L_S     11     L_D                    OUT

$\frac{\lambda}{4}$        $\frac{\lambda}{4}$

V_S
(< V_PO)
(≅ IV)

V_D
(≅ 3V)

V_g2
(-IV)

Fig. 1

GATE o——Rg——————C_gd——————————Rd——oDRAIN

C_gs

R_i         Gm         C_ds        R_o

R_s
o SOURCE

Fig. 2

C_IN

R_IN

INPUT

C_OUT        R_OUT

OUTPUT

Fig. 8

1

*Fig. 3*

Fig. 4

Fig. 5

Fig. 6

Fig. 7